# EUROPÄISCHE PATENTANMELDUNG

(11) **EP 1 647 827 A1**
(43) Veröffentlichungstag der Anmeldung: **19.04.2006**
(21) Anmeldenummer: 05021867.6
(22) Anmeldetag: 07.10.2005
(51) Int. Cl.: G01R 31/26

(54) **Testsystem für Solarzellen**

(30) Priorität: 16.10.2004 DE 102004050463
(71) Anmelder: Manz Automation AG, 72768 Reutlingen (DE)
(72) Erfinder: Manz, Dieter, 72141 Walddorfhäslach (DE)
(74) Vertreter: Kohler Schmid Möbus

(57) **Zusammenfassung**

Ein Testsystem (1) zum Überprüfen der Fertigungsqualität von Solarzellen (2) mit einer im Testbereich angeordneten optischen Prüfeinrichtung (3, 3', 3") zur Sichtprüfung der Solarzellen und einer elektrischen Prüfeinrichtung (4) zur Prüfung der elektrischen Funktionen der Solarzellen mit einer Beleuchtungseinrichtung (5) zur Bestrahlung der Solarzellen sowie einer elektrischen Kontaktiereinrichtung (6) zum Abgreifen von Spannungen an den Kontakten der Solarzellen ist dadurch gekennzeichnet, dass ein gemeinsames, lineares Transportbandsystem (7) vorgesehen ist, welches den Testbereich durchläuft und eine Vakuumansaugeinrichtung zum Halten der Solarzellen auf einer Oberfläche des Transportbandsystems aufweist. Damit können die Zykluszeiten für die Prüfung der Solarzellen erheblich verringert und ein teurer Roboter zur Umsetzung der Solarzellen zwischen den einzelnen Transporteinrichtungen sowie der erhebliche Platzbedarf des üblichen Rundschalttisches eingespart werden, wobei gleichzeitig Beschädigungen beim Umsetzen der Solarzellen verhindert werden und eine höhere Genauigkeit der optischen Prüfung erzielt wird.

## Beschreibung

Die Erfindung betrifft ein Testsystem zum optischen und elektrischen Überprüfen der Fertigungsqualität und/oder der Bestimmung von optischen und elektrischen Eigenschaften von Solarzellen mit einer ersten Transporteinrichtung zum Befördern der Solarzellen in einen Testbereich, einer zweiten Transporteinrichtung zum Bewegen der Solarzellen durch den Testbereich und einer dritten Transporteinrichtung zum Befördern der Solarzellen aus dem Testbereich, sowie mit einer im Testbereich angeordneten optischen Prüfeinrichtung zur Sichtprüfung der Solarzellen und einer ebenfalls im Testbereich angeordneten elektrischen Prüfeinrichtung zur Prüfung der elektrischen Funktionen der Solarzellen, wobei die elektrische Prüfeinrichtung eine Beleuchtungseinrichtung zur Bestrahlung der lichtempfindlichen Flächen der Solarzellen mit Licht sowie eine elektrische Kontaktiereinrichtung zum Abgreifen von Spannungen und/oder Strömen an elektrischen Kontakten der Solarzellen umfasst.

Derartige Testsysteme werden üblicherweise über eine erste Transporteinrichtung in Form eines Förderbands mit den zu testenden Solarzellen beschickt. Im Testbereich werden die Solarzellen dann von einem Roboter aus der ersten Transporteinrichtung entnommen und auf einen Rundschalttisch aufgelegt, wo sie zeitlich getaktet der optischen Prüfeinrichtung zur Sichtprüfung sowie der elektrischen Prüfeinrichtung zur Funktionsprüfung zugeführt werden. Die optische Prüfeinrichtung umfasst bei bekannten Testsystemen in der Regel eine Flächenkamera, die in Stillstandszeiten der Taktung die Oberfläche der zu testenden Solarzelle detektiert. Eventuelle Unregelmäßigkeiten werden dann entweder durch einen Menschen oder von einem Auswertungscomputer erkannt und die entsprechende Solarzelle als nicht oder nur bedingt tauglich eingestuft. In der Taktung des Rundschalttisches wird an einer anderen Stelle im Testbereich sodann eine elektrische Kontaktierung mit der zu untersuchenden Solarzelle vorgenommen, um die elektrischen Funktionen zu prüfen. Dabei wird die lichtempfindliche Fläche der Solarzelle mit Licht bestrahlt und an entsprechenden Kontakten der Solarzelle die auftretenden Ströme und/oder Spannungen gemessen. Auch die elektrische Prüfung erfolgt üblicherweise während einer Stillstandszeit des Rundschalttisches.

Nach Abschluss der Prüfungen wird die geprüfte Solarzelle von dem gleichen oder einem anderen Roboterarm wieder vom Rundschalttisch entnommen und in eine dritte Transporteinrichtung übergeben, wo sie entsprechend den Prüfergebnissen einer bestimmten Qualitätsklasse zugeordnet und mit einer meist linearen Bandeinrichtung abtransportiert wird. Die gesamte Zykluszeit für einen solchen Testzyklus beträgt bei bekannten Testsystemen derzeit zwischen drei und fünf Sekunden.

Neben dieser relativ langen Taktzeit haben die bekannten Testsysteme aber auch noch weitere Nachteile:

Durch den Einsatz von Roboterarmen und Rundschalttischen sind derartige Einrichtungen relativ kostenintensiv und platzaufwändig.

Beim Umsetzen der zu testenden Solarzellen von der ersten Transporteinrichtung auf die zweite Transporteinrichtung und nach Abschluss der Prüfung von der zweiten Transporteinrichtung auf die dritte Transporteinrichtung kommen häufig Beschädigungen angelieferter oder bereits geprüfter Solarzellen vor, sodass einerseits Ausschuss entsteht, andererseits die anschließende Sortierung nach Qualitätsklassen nicht völlig zuverlässig ist.

Beim Einspannen der zu testenden Solarzellen in die Halterungseinrichtungen des Rundschalttisches weisen die Solarzellen meist eine gewisse Welligkeit auf, die wiederum die Genauigkeit und Aussagekraft der optischen Prüfung beeinträchtigen kann.

Aufgabe der vorliegenden Erfindung ist es demgegenüber, ein Testsystem der eingangs genannten Art mit möglichst einfachen technischen Mitteln dahin gehend zu verbessern, dass einerseits die Zykluszeiten für die Prüfung der Solarzellen erheblich verringert werden können, andererseits der teure Roboter zur Umsetzung der Solarzellen zwischen den einzelnen Transporteinrichtungen sowie der erhebliche Platzbedarf des Rundschalttisches eingespart werden kann, wobei gleichzeitig Beschädigungen beim Umsetzen der Solarzellen verhindert werden sollen und eine höhere Genauigkeit der optischen Prüfung erzielt wird.

Erfindungsgemäß wird diese Aufgabe auf ebenso überraschend einfache wie wirkungsvolle Art und Weise dadurch gelöst, dass die erste, zweite und dritte Transporteinrichtung ein gemeinsames, lineares Transportbandsystem umfassen, welches den Testbereich durchläuft und eine Vakuumansaugeinrichtung zum Halten der Solarzellen auf einer Oberfläche des Transportbandsystems aufweist. Durch die Zusammenlegung der Transporteinrichtungen zu einem gemeinsamen, linearen Transportbandsystem, dessen einzelne, linear fördernde Transportbänder gegebenenfalls auch unter einem Winkel zueinander angeordnet sein können, entfällt der kostenintensive Roboter sowie der platzaufwändige Rundschalttisch. Ein Umsetzen der Solarzellen vor und nach dem Durchlaufen des Testbereichs ist nicht mehr erforderlich, sodass hierbei auch keine Beschädigungen und falsche Einsortierungen in Qualitätsklassen auftreten können. Aufgrund der Vakuumsaugeinrichtungen zum Halten der Solarzellen werden diese geglättet und stehen im Testbereich der optischen Prüfeinrichtung eben gegenüber, sodass die Sichtprüfung auf mechanische Fehler wesentlich präziser durchgeführt werden kann. Schließlich lässt sich durch die lineare Führung auch die Zykluszeit in der Prüfeinrichtung erheblich verringern, sodass Zykluszeiten von weniger als zwei Sekunden, im kontinuierlichen Betrieb sogar Prüfzeiten in der Größenordnung von einer Sekunde erzielbar sind.

Besonders bevorzugt ist eine Ausführungsform des erfindungsgemäßen Testsystems, bei der die Solarzellen mit ihren lichtempfindlichen Flächen nach oben auf dem Transportbandsystem angeordnet sind, und wobei die Beleuchtungseinrichtung der elektrischen Prüfeinrichtung im Testbereich oberhalb des Transportbandsystems und die elektrische Kontaktiereinrichtung unterhalb und/oder seitlich des Transportbandsystems angebracht sind. Auf diese Weise kann das Testsystem im Testbereich besonders kompakt und Platz sparend aufgebaut werden.

Vorteilhaft ist auch eine Ausführungsform der Erfindung, bei der das Transportbandsystem mindestens zwei parallel zur Transportrichtung verlaufende Parallelbänder umfasst, von denen mindestens eines zur Bandoberfläche hin geöffnete, mit der Vakuumansaugeinrichtung verbundene Durchbrüche aufweist. Die Aufteilung des Transportbands in mehrere Parallelbänder verringert einerseits die zu bewegende Masse des Bandes, andererseits wird bei geeigneter geometrischer Gestaltung dennoch eine genügend große und sichere Auflagefläche für die zu transportierenden Solarzelle bereitgestellt.

Besonders bevorzugt ist eine Weiterbildung dieser Ausführungsform, bei der die Parallelbänder in einer Richtung quer zur Transportrichtung des Transportbandes voneinander beabstandet sind. Auf diese Weise wird ein Zugriff auf die transportierten Solarzellen von unten her möglich.

Dies kann insbesondere mit großem Vorteil dadurch ausgenutzt werden, dass zumindest ein Teil der Kontaktiereinrichtung der elektrischen Prüfeinrichtung im Testbereich in den Lücken zwischen den Parallelbändern unterhalb des Transportbandes angeordnet ist. Die elektrische Kontaktiereinrichtung kann dann von unten her durch die Bandlücke auf die elektrischen Kontakte der jeweils zu testenden Solarzelle zugreifen.

Geometrisch besonders günstig ist eine Weiterbildung der oben beschriebenen Ausführungsform, bei welcher das Transportbandsystem genau drei Parallelbänder umfasst, von denen zumindest das mittlere zur Bandoberfläche hin geöffnete, mit der Vakuumansaugeinrichtung verbundene Durchbrüche aufweist.

Um eine absolut plane Lage der zu testenden Solarzelle zu erreichen, können (zumindest im Testbereich) sämtliche Parallelbänder zur Bandoberfläche hin geöffnete, mit der Vakuumansaugeinrichtung verbundene Durchbrüche aufweisen.

Die Genauigkeit der optischen Messung kann auch dadurch weiter verbessert werden, dass die mit der Vakuumansaugeinrichtung verbundenen Durchbrüche gleichmäßig über die Oberfläche des jeweiligen Parallelbandes verteilt sind, wodurch ein besonders gleichmäßiges Ansaugen der Solarzelle über ihre gesamte Fläche garantiert wird.

Vorteilhaft ist auch eine Weiterbildung der obigen Ausführungsform, bei welcher die Parallelbänder des Transportbandsystems gemeinsam angetrieben werden, aber zu Justagezwecken unabhängig voneinander in Transportrichtung bewegt werden können. Dadurch können Schieflagen der zu befördernden Solarzellen ausgeglichen bzw. vermieden werden.

Eine weitere besonders bevorzugte Ausführungsform des erfindungsgemäßen Testsystems zeichnet sich dadurch aus, dass das Transportbandsystem mehrere in Transportrichtung aufeinander folgende Bandsegmente umfasst, deren Länge jeweils ein Vielfaches der Länge einer Solarzelle beträgt, wobei im Betrieb eine am Bandende eines Bandsegments ankommende Solarzelle auf den Bandanfang eines nachfolgenden Bandsegments und vom letzten Bandsegment an eine weitere Einrichtung, insbesondere eine Sortiereinrichtung übergeben wird. Die einzelnen Bandsegmente können daher erheblich kürzer als ein durchgehendes Transportband gestaltet werden. Damit sind auch Anpassungen an räumliche Erfordernisse in der individuellen Anwendung möglich.

Bei einer besonders bevorzugten Weiterbildung werden die Bandsegmente synchron angetrieben, um einen gleichmäßigen Durchlauf der geförderten Solarzellen zu bewirken.

Vorteilhaft ist auch eine Weiterbildung dieser Ausführungsform, bei welcher aufeinander folgende Bandsegmente in Transportrichtung um weniger als eine Solarzellenlänge räumlich voneinander beabstandet sind. Auf diese Weise sind keine gesonderten Übergabeeinrichtungen für die zu transportierenden Solarzellen von einem Band zum nächsten erforderlich.

Während bei Testsystemen nach dem Stand der Technik bislang für die optische Prüfung Flächenkameras eingesetzt werden, die in Stillstandszeiten einer Taktung die Oberfläche der jeweiligen Solarzelle vermessen, ist bei einer bevorzugten Ausführung des erfindungsgemäßen Testsystems vorgesehen, dass die optische Prüfeinrichtung mindestens eine Zeilenkamera umfasst, die vorzugsweise von oben her die auf dem Transportbandsystem vorbei laufenden Solarzellen erfasst. Auf diese Weise kann die optische Prüfung auch kontinuierlich ohne Stillstandszeiten der Transporteinrichtung durchgeführt werden.

Besonders vorteilhaft ist es dabei, wenn die Zeilenkamera in Synchronisation mit der Laufgeschwindigkeit des Transportbandsystems arbeitet, sodass eine optische Überprüfung der gesamten Sichtfläche der zu prüfenden Solarzelle sichergestellt werden kann.

Ganz besonders bevorzugt ist eine Weiterbildung, bei welcher die Zeilenkamera in einer Lücke zwischen aufeinander folgenden Bandsegmenten angeordnet ist. Auf diese Weise kann die optische Prüfeinrichtung besonders kompakt und Platz sparend gestaltet werden.

Die Zykluszeit zur Prüfung der Solarzelle lässt sich bei Ausführungsformen der Erfindung erheblich verringern, wenn die optische Prüfeinrichtung so ausgestaltet ist, dass die Sichtprüfung der Solarzellen im Betrieb bei laufendem Transportbandsystem, insbesondere kontinuierlich erfolgen kann.

Bei weiteren Ausführungsformen des erfindungsgemäßen Testsystems kann die elektrische Prüfeinrichtung so ausgestaltet sein, dass die Prüfung der elektrischen Funktionen der Solarzellen getaktet jeweils in einer Stillstandsperiode zwischen zwei Transportperioden der Transporteinrichtung erfolgen kann. Damit lassen sich Zykluszeiten für die Prüfung der Solarzellen im Bereich von weniger als zwei Sekunden erzielen.

Ganz besonders bevorzugt ist jedoch eine Ausführungsform des erfindungsgemäßen Testsystems, bei welcher die elektrische Kontaktiereinrichtung abschnittsweise mit einer vorbeilaufenden Solarzelle mitlaufende Kontakte aufweist, welche nach Durchlaufen des Abschnitts automatisch wieder in ihre Ausgangslage zurückkehren, und bei welcher die elektrische Prüfeinrichtung so ausgestaltet ist, dass die Prüfung der elektrischen Funktionen der Solarzellen im Betrieb bei laufendem Transportbandsystem erfolgen kann. In diesem kontinuierlichen Betrieb lassen sich Zykluszeiten für die Prüfung der Solarzellen von etwa einer Sekunde und darunter erreichen.

Weitere Merkmale und Vorteile der Erfindung ergeben sich aus der nachfolgenden detaillierten Beschreibung von Ausführungsbeispielen der Erfindung anhand der Figuren der Zeichnung, die erfindungswesentliche Einzelheiten zeigt, sowie aus den Ansprüchen. Die einzelnen Merkmale können je einzeln für sich oder zu mehreren in beliebigen Kombinationen bei Varianten der Erfindung verwirklicht sein.

In der schematischen Zeichnung sind Ausführungsbeispiele der Erfindung dargestellt, welche in der nachfolgenden Beschreibung näher erläutert werden.

Es zeigen:
- Fig. 1a: eine schematische Draufsicht auf eine Ausführungsform des erfindungsgemäßen Testsystems von oben;
- Fig. 1b: eine schematische Seitenansicht der Ausführungsform nach Fig. 1a;
- Fig. 2: ein Testsystem nach dem Stand der Technik.

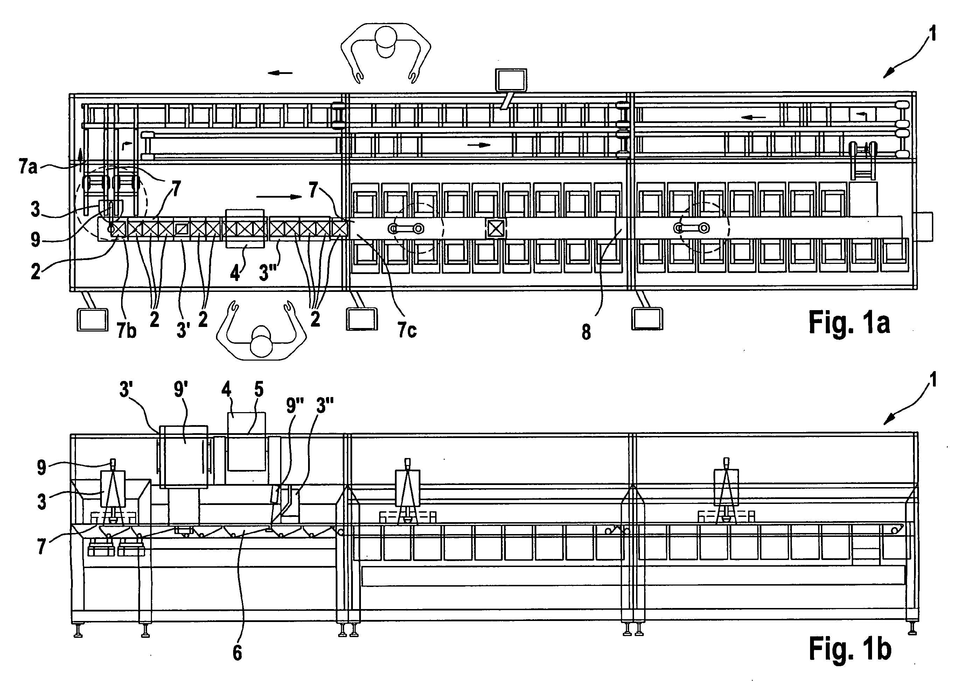

Die in den Figuren 1a und 1b gezeigte Ausführungsform eines erfindungsgemäßen Testsystems 1 zum optischen und elektrischen Überprüfen der Fertigungsqualität und/oder der Bestimmung von optischen und elektrischen Eigenschaften von Solarzellen 2 umfasst eine optische Prüfeinrichtung 3, 3', 3" zur Sichtung der Solarzellen 2, die in einem Testbereich des Testsystems 1 angeordnet ist und beim vorliegenden Ausführungsbeispiel u. a. die optische Überprüfung auf Richtigkeit und Vollständigkeit aufgedruckter Leiterelemente auf der Oberfläche der Solarzellen 2, eine Prüfung auf richtige Farbe und Geometrie der Solarzellen 2 sowie eine dreidimensionale optische Kontrolle beispielsweise auf in den aufgedruckten Leiterelementen befindliche Splitter oder andere Fremdkörper enthält. Ebenfalls im Testbereich des Testsystems 1 angeordnet ist eine elektrische Prüfeinrichtung 4 zur Überprüfung der elektrischen Funktionen der Solarzellen 2. Diese umfasst eine Beleuchtungseinrichtung 5 zur Bestrahlung der lichtempfindlichen Flächen der Solarzellen 2 mit Licht sowie eine elektrische Kontaktiereinrichtung 6 zum Abgreifen von Spannungen und/oder Strömen an elektrischen Kontakten der Solarzellen 2. Dabei ist die Beleuchtungseinrichtung 5 im Testbereich oberhalb und die elektrische Kontaktiereinrichtung 6 unterhalb und/oder oberhalb der vorbeilaufenden zu prüfenden Solarzellen 2 angeordnet.

Die zu überprüfenden Solarzellen 2 werden dem Testbereich mit einer ersten Transporteinrichtung zugeführt, innerhalb des Testbereichs mit einer zweiten Transporteinrichtung bewegt und schließlich mit einer dritten Transporteinrichtung aus dem Testbereich herausbefördert. Erfindungsgemäß umfassen diese drei Transporteinrichtungen ein gemeinsames, lineares Transportbandsystem 7, welches im vorliegenden Ausführungsbeispiel aus mehreren in Transportrichtung aufeinander folgenden, synchron angetriebenen und um weniger als eine Solarzellenlänge räumlich voneinander beabstandeten Bandsegmenten 7a ... 7c aufgebaut ist, deren Länge jeweils ein Vielfaches einer Solarzelle 2 beträgt, wobei im Betrieb eine am Bandende eines Bandsegments ankommende Solarzelle 2 auf den Bandanfang eines nachfolgenden Bandsegments und vom letzten Bandsegment 7c an eine Sortiereinrichtung 8 zur Einordnung in verschiedene Qualitätsklassen aufgrund der gemessenen Prüfergebnisse übergeben wird.

Das Transportbandsystem 7 weist eine in der Zeichnung nicht näher dargestellte Vakuumansaugeinrichtung zum Halten der Solarzellen 2 auf einer Oberfläche des Transportbandsystems auf. Damit werden die zu fördernden Solarzellen 2 verrutschsicher gehalten und außerdem eventuell vorhandene Wellen oder Unebenheiten der Solarzellen 2 geglättet, sodass insbesondere ihre optische Überprüfung in der optischen Prüfeinrichtung 3, 3', 3" problemlos erfolgen kann.

Der genaue Aufbau der Transportbänder des Transportbandsystems 7 ist in der Zeichnung nicht näher dargestellt. Vorzugsweise umfassen die Transportbänder drei parallel zur Transportrichtung verlaufende Parallelbänder, von denen zumindest das mittlere zur Bandoberfläche hin geöffnete, mit der Vakuumansaugeinrichtung verbundene Durchbrüche aufweist. Durch die Bandlücken kann von unten her insbesondere die elektrische Kontaktiereinrichtung 6 an die vorbeilaufenden, zu prüfenden Solarzellen 2 angreifen. Zu Justagezwecken können die Parallelbänder des Transportbandsystems 7 auch unabhängig voneinander in Transportrichtung bewegt werden.

Die optische Prüfeinrichtung 3 umfasst eine Flächenkamera 9, die in einer Lücke zwischen aufeinander folgenden Bandsegmenten 7a, 7b angeordnet ist und als Positionsindikator mit einer nicht näher gezeigten Entlade-Einrichtung zum Vereinzeln der in Stapeln angelieferten Solarzellen 2 zusammenwirkt. Außerdem weist die optische Prüfeinrichtung 3' einen Abschnitt auf, (der bei anderen Ausführungsformen ebenfalls in einer Bandlücke angeordnet sein kann, und) der eine Zeilenkamera 9' enthält. Auch in dem nachfolgenden Abschnitt der optischen Prüfeinrichtung 3" kann eine Zeilenkamera 9" zur optischen Abtastung der Oberfläche der jeweils vorbeilaufenden Solarzellen 2 vorgesehen sein.

Sowohl die optische als auch die elektrische Prüfung der Solarzellen 2 kann im Betrieb bei laufendem Band, insbesondere kontinuierlich und ohne Stillstand der Solarzellen-Förderung erfolgen. Dazu sind (in der Zeichnung nicht näher dargestellt) die elektrische Prüfeinrichtung 4 und insbesondere deren Kontaktiereinrichtung 6 so ausgestaltet, dass die Prüfung der elektrischen Funktionen der vorbeilaufenden Solarzellen 2 durch abschnittsweise mitlaufende Kontakte durchgeführt wird, welche nach dem Durchlaufen des Abschnitts automatisch wieder in ihre Ausgangslage zurückkehren. Alternativ kann die elektrische Prüfung allerdings auch getaktet jeweils in einer Stillstandsperiode zwischen zwei Transportperioden der Transporteinrichtung erfolgen.

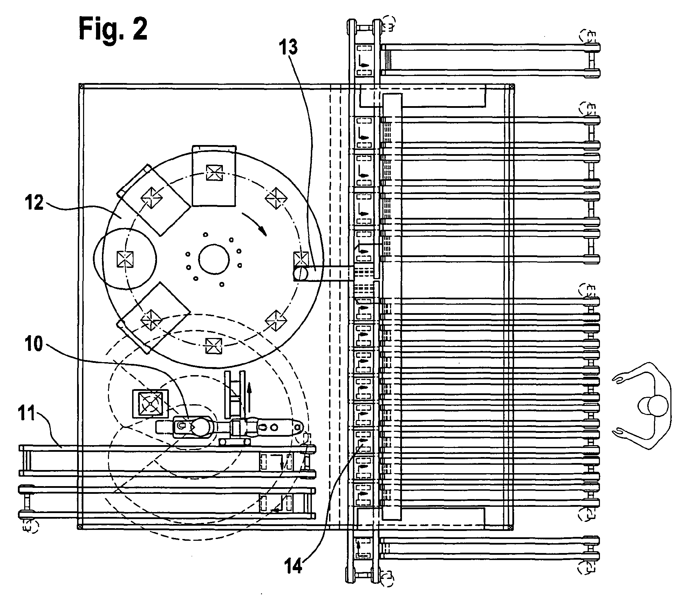

Das in Fig. 2 schematisch dargestellte Testsystem nach dem eingangs beschriebenen Stand der Technik enthält einen Roboterarm 10, mit welchem von einer als Förderband ausgestalteten ersten Transporteinrichtung 11 angelieferte Solarzellen 2 entnommen und einer als Rundschalttisch 12 ausgestalteten zweiten Transporteinrichtung zugeführt werden. Der Rundschalttisch 12 befördert die zu prüfenden Solarzellen 2 getaktet jeweils an schematisch dargestellte optische und elektrische Messstationen. Nach Abschluss der Messungen wird die geprüfte Solarzelle 2 vom Roboterarm 10 der entsprechenden Station des Rundschalttisches 12 entnommen und einer als Übergabeband 13 ausgestalteten dritten Transporteinrichtung übergeben, welche die Solarzelle einer Sortiereinrichtung 14 übergibt, in der sie je nach geprüfter Qualitätsstufe einer weiteren Verarbeitung oder Versendung zugeführt wird.

### Bezugiszeichenliste:

- 1: Testsystem
- 2: Solarzellen
- 3, 3', 3": optische Prüfeinrichtung
- 4: elektrische Prüfeinrichtung
- 5: Beleuchtungseinrichtung
- 6: elektrische Kontaktiereinrichtung
- 7: lineares Transportbandsystem
- 7a, 7b, 7c: Bandsegmente
- 8: Sortiereinrichtung
- 9: Flächenkamera
- 9', 9": Zeilenkamera
- 10: Roboterarm
- 11: Förderband (= erste Transporteinrichtung)
- 12: Rundschalttisch (= zweite Transporteinrichtung)
- 13: Übergabeband (= dritte Transporteinrichtung)
- 14: Sortiereinrichtung

## Patentansprüche

1. Testsystem (1) zum optischen und elektrischen Überprüfen der Fertigungsqualität und/oder der Bestimmung von optischen und elektrischen Eigenschaften von Solarzellen (2) mit einer ersten Transporteinrichtung zum Befördern der Solarzellen (2) in einen Testbereich, einer zweiten Transporteinrichtung zum Bewegen der Solarzellen (2) durch den Testbereich und einer dritten Transporteinrichtung zum Befördern der Solarzellen (2) aus dem Testbereich, sowie mit einer im Testbereich angeordneten optischen Prüfeinrichtung (3, 3', 3") zur Sichtprüfung der Solarzellen (2) und einer ebenfalls im Testbereich angeordneten elektrischen Prüfeinrichtung (4) zur Prüfung der elektrischen Funktionen der Solarzellen (2), wobei die elektrische Prüfeinrichtung (4) eine Beleuchtungseinrichtung (5) zur Bestrahlung der lichtempfindlichen Flächen der Solarzellen (2) mit Licht sowie eine elektrische Kontaktiereinrichtung (6) zum Abgreifen von Spannungen und/oder Strömen an elektrischen Kontakten der Solarzellen (2) umfasst,
**dadurch gekennzeichnet,**
**dass** die erste, zweite und dritte Transporteinrichtung ein gemeinsames, lineares Transportbandsystem (7) umfassen, welches den Testbereich durchläuft und eine Vakuumansaugeinrichtung zum Halten der Solarzellen (2) auf einer Oberfläche des Transportbandsystems (7) aufweist.

2. Testsystem nach Anspruch 1, **dadurch gekennzeichnet, dass** die Solarzellen (2) mit ihren lichtempfindlichen Flächen nach oben auf dem Transportbandsystem (7) angeordnet sind, und dass die Beleuchtungseinrichtung (5) der elektrischen Prüfeinrichtung (4) im Testbereich oberhalb des Transportbandsystems (7) und die elektrische Kontaktiereinrichtung (6) unterhalb und/oder oberhalb des Transportbandsystems (7) angebracht sind.

3. Testsystem nach einem der vorhergehenden Ansprüche, **dadurch gekennzeichnet, dass** das Transportbandsystem (7) mindestens zwei parallel zur Transportrichtung verlaufende Parallelbänder umfasst, von denen mindestens eines zur Bandoberfläche hin geöffnete, mit der Vakuumansaugeinrichtung verbundene Durchbrüche aufweist.

4. Testsystem nach Anspruch 3, **dadurch gekennzeichnet, dass** die Parallelbänder in einer Richtung quer zur Transportrichtung des Transportbandsystems (7) voneinander beabstandet sind.

5. Testsystem nach Anspruch 4, **dadurch gekennzeichnet, dass** zumindest ein Teil der Kontaktiereinrichtung (6) der elektrischen Prüfeinrichtung (4) im Testbereich in den Lücken zwischen den Parallelbändern unterhalb des Transportbandsystems (7) angeordnet ist.

6. Testsystem nach einem der Ansprüche 3 bis 5, **dadurch gekennzeichnet, dass** das Transportbandsystem (7) genau drei Parallelbänder umfasst, von denen zumindest das mittlere zur Bandoberfläche hin geöffnete, mit der Vakuumansaugeinrichtung verbundene Durchbrüche aufweist.

7. Testsystem nach einem der Ansprüche 3 bis 6, **dadurch gekennzeichnet, dass** sämtliche Parallelbänder zur Bandoberfläche hin geöffnete, mit der Vakuumansaugeinrichtung verbundene Durchbrüche aufweisen.

8. Testsystem nach einem der Ansprüche 3 bis 7, **dadurch gekennzeichnet, dass** die mit der Vakuumansaugeinrichtung verbundenen Durchbrüche gleichmäßig über die Oberfläche des jeweiligen Parallelbandes verteilt sind.

9. Testsystem nach einem der Ansprüche 3 bis 8, **dadurch gekennzeichnet, dass** die Parallelbänder des Transportbandsystems (7) gemeinsam angetrieben werden, aber zu Justagezwecken unabhängig voneinander in Transportrichtung bewegt werden können.

10. Testsystem nach einem der vorhergehenden Ansprüche, **dadurch gekennzeichnet, dass** das Transportbandsystem (7) mehrere in Transportrichtung aufeinander folgende Bandsegmente (7a, ... , 7c) umfasst, deren Länge jeweils ein Vielfaches der Länge einer Solarzelle (2) beträgt, wobei im Betrieb eine am Bandende eines Bandsegments ankommende Solarzelle (2) auf den Bandanfang eines nachfolgenden Bandsegments und vom letzten Bandsegment an eine weitere Einrichtung, insbesondere eine Sortiereinrichtung (8) übergeben wird.

11. Testsystem nach Anspruch 10, **dadurch gekennzeichnet, dass** die Bandsegmente (7a, ..., 7c) synchron angetrieben werden.

12. Testsystem nach Anspruch 10 oder 11, **dadurch gekennzeichnet, dass** aufeinander folgende Bandsegmente (7a, ..., 7c) in Transportrichtung um weniger als eine Solarzellenlänge räumlich voneinander beabstandet sind.

13. Testsystem nach einem der vorhergehenden Ansprüche, **dadurch gekennzeichnet, dass** die optische Prüfeinrichtung (3) mindestens eine Zeilenkamera (9', 9") umfasst, die vorzugsweise von oben her die auf dem Transportbandsystem (7) vorbei laufenden Solarzellen (2) erfasst.

14. Testsystem nach Anspruch 13, **dadurch gekennzeichnet, dass** die Zeilenkamera (9', 9") in Synchronisation mit der Laufgeschwindigkeit des Transportbandsystems (7) arbeitet.

15. Testsystem nach Anspruch 12 und einem der Ansprüche 13 oder 14, **dadurch gekennzeichnet, dass** die Zeilenkamera (9', 9") in einer Lücke zwischen aufeinander folgenden Bandsegmenten (7a, ..., 7c) angeordnet ist.

16. Testsystem nach einem der vorhergehenden Ansprüche, **dadurch gekennzeichnet, dass** die optische Prüfeinrichtung (3, 3', 3") so ausgestaltet ist, dass die Sichtprüfung der Solarzellen (2) im Betrieb bei laufendem Transportbandsystem (7), insbesondere kontinuierlich erfolgen kann.

17. Testsystem nach einem der vorhergehenden Ansprüche, **dadurch gekennzeichnet, dass** die elektrische Prüfeinrichtung (4) so ausgestaltet ist, dass die Prüfung der elektrischen Funktionen der Solarzellen (2) getaktet jeweils in einer Stillstandsperiode zwischen zwei Transportperioden der Transporteinrichtung erfolgen kann.

18. Testsystem nach einem der Ansprüche 1 bis 16, **dadurch gekennzeichnet, dass** die elektrische Kontaktiereinrichtung (6) abschnittsweise mit einer vorbeilaufenden Solarzelle (2) mitlaufende Kontakte aufweist, welche nach Durchlaufen des Abschnitts automatisch wieder in ihre Ausgangslage zurückkehren, und dass die elektrische Prüfeinrichtung (4) so ausgestaltet ist, dass die Prüfung der elektrischen Funktionen der Solarzellen (2) im Betrieb bei laufendem Transportbandsystem (7) erfolgen kann.
